# EUROPEAN PATENT SPECIFICATION

(11) **EP 3 020 077 B1**
(45) Date of publication and mention of the grant of the patent: **03.05.2017**
(21) Application number: 14750601.8
(22) Date of filing: 14.07.2014
(51) Int. Cl.: H01L 35/30, F01N 5/02, F28F 13/18, F28D 15/02, F28D 21/00

(54) **THERMOELECTRIC GENERATOR**
THERMOELEKTRISCHER GENERATOR
GÉNÉRATEUR THERMOÉLECTRIQUE

(30) Priority: 12.07.2013 GB 201312535
(43) Date of publication of application: 18.05.2016
(73) Proprietor: European Thermodynamics Limited, Kibworth, Leicester LE8 0RX (GB)
(72) Inventor: SIMPSON, Kevin, Kibworth Leicestershire LE8 0RX (GB); CHIWANGA, States, Cambridge Cambridgeshire CB3 0GT (GB); ROUAUD, Cedric, Hove West Sussex BN3 6DQ (GB)
(74) Representative: Braddon, Nicholas
(86) International application number: PCT/GB2014/052144
(87) International publication number: WO 2015/004486

(56) References cited:
- DE-A1-102010 002 493
- JP-A- 2005 083 251
- US-A- 3 256 703
- US-A1- 2005 172 992
- US-A1- 2008 017 356
- US-A1- 2010 095 996
- US-A1- 2012 103 381
- US-B1- 6 222 112

## Description

The present invention relates to a thermoelectric generator. More specifically, the present invention relates to a thermoelectric generator for generating useful power from waste heat in a flow of gas, such as in an exhaust from an engine.

It is well known that automotive internal combustion engines have efficiencies that are typically of the order of 30% to 35%, which means that around 70% of the heat energy in the fuel is wasted. There is a need to improve the fuel efficiency of automotive engines, and engines in general.

Engines convert potential energy stored in their fuel into useful mechanical power. This is often in turn used to generate electrical power, for instance, using an alternator. Electrical energy can conveniently be stored, and/or converted back into mechanical work with a relatively high efficiency. One way of improving the efficiency of an engine is therefore to produce useful electrical energy from waste heat leaving the engine. In a vehicle, this will tend to reduce the mechanical load on the engine from the alternator, thereby improving fuel economy.

It is known to use thermoelectric generators (or TEGs) to produce electrical power from waste heat in the exhaust gases from an internal combustion engine. Such thermoelectric generators comprise at least one thermoelectric module (or TEM).

TEMs comprise materials that convert a temperature difference directly into an electromotive force. The electromotive force (or voltage) produced by a TEM is substantially proportional to the temperature gradient across the TEM. The greater the difference in temperature between a hot side and a cold side of a TEM, the more electrical power will be produced by the TEM in response thereto.

A known technique to maximise the temperature gradient across a TEM in contact with a heat source is to cool the cold side thereof. In a thermoelectric generator adapted to produce electricity from exhaust waste heat, the hot side of each TEM may be arranged to be in thermal contact with a hot exhaust gas, and the cold side may be in thermal contact with a coolant fluid, such as air or water. In some prior art arrangements, a liquid coolant such as water is used, in a forced convection heat transfer mode. In some arrangements, the TEG may be cooled as part of the engine coolant circuit, using the same radiator and pressurised coolant system as the engine itself.
It can be very difficult to extract sufficient heat flux from the limited area of the cold side of each TEM to maintain a large temperature difference across each TEM.
In order to address this problem, it is known to arrange the hot side of each TEM in thermal contact with a heat spreader. The heat spreader comprises a thermally conductive material that is suitable for use at high temperatures, and may comprise nickel or stainless steel. The heat spreader conducts heat away from the limited area of the cold side of the TEM, and may be provided with a larger area from which the heat spreader may reject heat into the coolant fluid.
One problem with existing thermoelectric generators is that such heat spreaders and their associated liquid cooling arrangement can be heavy and expensive to produce. Even when an existing liquid cooling system is adapted to accommodate the heat load from the TEG, there are significant penalties in cost and weight. Furthermore, it may be challenging to maintain a suitably low temperature on the cool side of the TEMs of the TEG.

US3256703 concerns a heat exchanger for a thermoelectric generator. The pool boiling heat exchanger comprises an expandable liquid coolant container. When the pressure of the vaporised coolant increases, the container expands, thereby providing a larger cooler surface area which the vapour can contact.

It is an object of the invention to overcome or ameliorate at least some of the above mentioned problems.
According to a first aspect of the invention, there is provided a method of generating electrical power from waste heat comprising: providing waste heat to a first surface of a thermoelectric module and cooling a second surface of the thermoelectric module using pool boiling of a coolant fluid, thereby producing electrical power from the thermoelectric module as a result of a temperature difference between the first surface and the second surface; condensing, at a condenser, a coolant vapour formed by pool boiling of the coolant fluid; and controlling the heat transfer conditions associated with rejecting heat from the second surface to the coolant fluid so as to maintain nucleate boiling of the coolant fluid in response to heat rejected from the second surface.

The very high effective heat transfer coefficients that are obtainable by pool boiling heat transfer in the nucleate boiling regime mean that the heat spreaders necessary in prior art devices can be dispensed with. This may substantially reduce the weight and cost of the thermoelectric generator. Furthermore, it may enable the thermal resistance between the thermoelectric generator and the coolant to be substantially reduced, since the intermediary layers of the heat spreader and any interconnecting or bonding layers (such as weld, braze or solder) are removed. The connection between the heat spreader and the thermoelectric module can be a common point of failure in prior art devices, due to the differing thermal co-efficient of expansion of the different materials. The method therefore enables more reliable thermoelectric generators. Moreover, the method may be practised at higher temperatures.

The heat flux through the second surface may be controlled by controlling the current through the thermoelectric module, thereby controlling the degree of heat transfer associated with the Peltier effect.

Controlling the current through the thermoelectric module may comprise controlling when a load is connected and/or disconnected from the thermoelectric module.

The boiling point of the coolant fluid may be controlled by controlling the pressure of the coolant fluid.

The pressure in the coolant fluid may be controlled by controlling a rate at which a coolant vapour, formed by boiling of the coolant fluid, is condensed at a condenser.

The coolant fluid and thermoelectric module may be arranged so that the coolant fluid is in direct contact with the second surface.

A surface morphology may be selected for the second surface that promotes nucleate boiling.

Selecting a surface morphology may comprise selecting a material for the second surface that is at least partially porous, or coating at least part of the second surface with a porous layer. The porous layer may comprise sintered particles, for example sintered metal or ceramic particles.

Selecting a surface morphology may comprise patterning the second surface with a plurality of nucleation sites for nucleation of boiling.

Patterning the surface may comprise machining the second surface to create an array of cavities and/or protrusions, the cavities and/or protrusions comprising nucleation sites. Each cavity and/or protrusion may comprise at least one nucleation site.

The cavities and protrusions may comprise an array of fins, each comprising a protrusion, with cavities defined therebetween.

The waste heat may be provided at a temperature of at least 400°C, or at least 500°C.

The waste heat may be from a vehicle, for example a car, truck, bus, motorcycle, skidoo, aircraft or a boat.

The waste heat may be exhaust waste heat.

The method of any preceding claim, comprising using an insulation means to insulate a further surface of the thermoelectric module.

The insulation means may be provided by depositing an insulating layer onto the further surface.

The insulation means may comprise a gas.

The gas may be substantially chemically inert.

The method may comprise housing the gas in a hermetically sealed container.

The method may comprise forming the thermoelectric modules directly onto a surface of a waste heat source.

The method may comprise forming or depositing the thermoelectric modules and the insulation means directly onto a surface of a waste heat source.

In a vehicle, the thermoelectric module may be located upstream of or downstream from a catalytic converter or a diesel particulate filter.

According to a second aspect of the invention, there is provided a thermoelectric generator for use with a waste heat source, the thermoelectric generator comprising: a coolant housing; a condenser; a thermoelectric module comprising a first surface and a second surface; and a controller which is configured to control the heat transfer conditions associated with rejecting heat from the second surface to the coolant fluid so as to maintain nucleate boiling of the coolant fluid in response to heat rejected from the second surface. The thermoelectric module is arranged so that, in use, the first surface receives heat from the waste heat source, and the second surface rejects heat into a coolant fluid within the coolant housing, so as to generate electrical power from the resulting temperature difference between the first surface and the second surface. The coolant housing is arranged to receive a liquid coolant fluid from the condenser, to house the liquid coolant fluid that receives heat from the second surface of the thermoelectric module so as to produce a coolant fluid vapour by pool boiling, and to communicate the coolant fluid vapour to the condenser. The condenser is configured to condense the coolant fluid vapour to produce liquid coolant fluid.

The controller may comprise a maximum power point tracking (MPPT) controller.

The controller may be configured to control the heat flux through the second surface by controlling the current flow through the thermoelectric module.

The controller may be configured to control the pressure of the coolant fluid within the fluid housing.

The controller may be configured to control the pressure of the coolant fluid by controlling a rate of condensation at the condenser.

The thermoelectric module may be arranged so that, in use, coolant fluid within the reservoir can be brought into direct contact with the second surface

The second surface may be configured to promote nucleate boiling.

The second surface may be at least partially porous, or comprise a porous layer. The porous layer may comprise sintered particles, for example sintered metal or ceramic particles.

The second surface may comprise an array of cavities and/or projections.

The thermoelectric generator may comprise insulation means arranged to insulate a further surface of the thermoelectric module.

The insulation means may be an insulating layer deposited onto the further surface.

The insulation means comprises a gas. The gas pressure may be lower than: 100 kPa, 50 kPa, 20 kPa, 10 kPa, 5 kPa, 2 kPa or 1 kPa.

The gas may be substantially chemically inert.

The thermoelectric generator may comprise a hermetically sealed container housing the gas.

The thermoelectric modules may be formed directly onto a surface of the waste heat source.

The waste heat source may comprise an exhaust conduit for receiving a flow of an exhaust gas, or an internal combustion engine.

The method of the first aspect of the invention may comprise using the thermoelectric generator according to the second aspect of the invention.

According to a third aspect of the invention, there is provided a structure with a heat source which produces an exhaust flow of hot gas, and a thermoelectric generator according to a second aspect of the invention arranged to produce electricity from the exhaust flow.

The structure may be a vehicle. The structure may be a building. The heat source may comprise means for burning fuel such as an engine. The structure may comprise a chimney. The structure may comprise an incinerator facility. The structure may comprise a power station. The structure may comprise a domestic dwelling. The heat source may comprise a stove, for example for burning wood and/or coal.

The invention will now be described, by way of example, with reference to the accompanying drawings, in which:
Figure 1 is a schematic perspective view of a thermoelectric generator according to a first embodiment of the invention, in which part of the thermoelectric generator is rendered partially transparent;
Figure 2 is an end view of the thermoelectric generator of Figure 1, in which the end flanges are omitted for clarity;
Figure 3 is a longitudinal cross section through the thermoelectric generator of Figure 1;
Figure 4 is a cross section through a thermoelectric generator module;
Figure 5 is a graph showing heat transfer with respect to the temperature difference between the surface temperature of the heat source and the saturation temperature of the coolant fluid;
Figure 6 is a graph, similar to that of Figure 5, illustrating hysteresis between different boiling regimes;
Figure 7 is a cross section through an alternative arrangement of thermoelectric generator module, comprising an insulating layer;
Figure 8 is a cross section through a further alternative thermoelectric generator module, which has been formed on a surface of a waste heat source;
Figure 9 is a plan view of a thermoelectric generator;
Figure 10 is a cross section through a thermoelectric generator module, insulated by a gas housed in a hermetic container; and
Figure 11 is a cross section of a thermoelectric generator in which the direction of heat flow through the thermoelectric module is substantially horizontal.

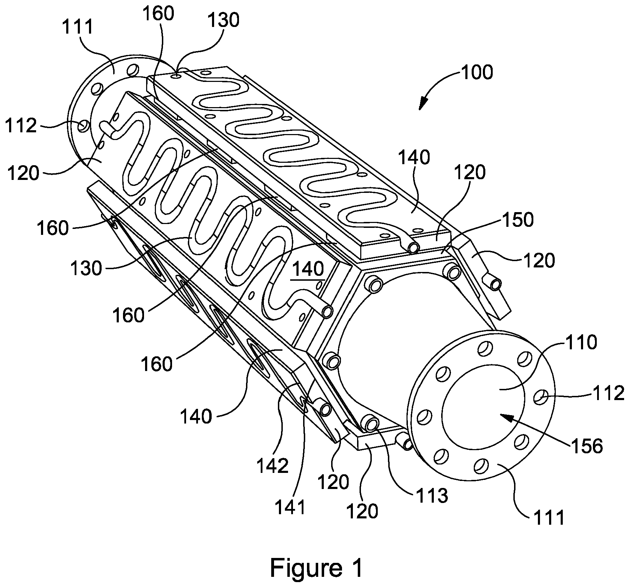

Referring to Figures 1 to 3, a thermoelectric generator 100 is shown, comprising an exhaust conduit 150 and a plurality of thermoelectric generator modules 120.

The exhaust conduit 150 comprises a substantially cylindrical flow channel 156 through which exhaust gases may pass. Flanged connectors 110 are attached to each end of the exhaust conduit 150 at a proximal end of each flanged connector 110 using a plurality of bolts 113. Each flanged connector 110 tapers down away from the exhaust conduit 150 to define a narrower cross section for the exhaust gases. The distal end of each flanged connector 110 is provided with a further flange 111, having a plurality of through holes 112, by which the thermoelectric generator 100 may conveniently be connected to an exhaust system.

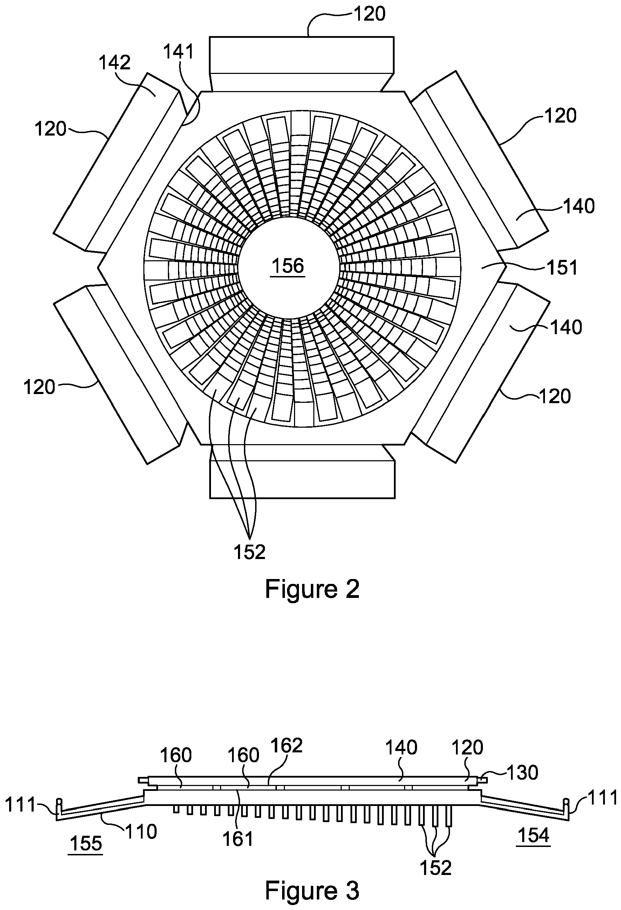

The interior of the exhaust conduit 150 is more clearly shown in Figures 2 and 3, and comprises a plurality of rods 152 that extend laterally into the flow channel 156, towards the axis of the flow channel 156. Each rod 152 is conveniently substantially cylindrical, but other shapes may be used. The rods 152 increase the contact area between the exhaust gases 155 and the exhaust conduit 150, thereby improving the efficiency with which heat is transferred therebetween. Conveniently, the rods 152 may vary in length in proportion to their location along the axis of the flow channel 156, with rods 152 near an inlet end of the flow channel 155 being shorter than rods near an outlet end of the flow channel 154. Varying the length of the rods 152 allows the lateral heat flux through the exhaust channel 150 at different longitudinal positions to be more uniform. Longer rods 152 result in an increased effective heat transfer co-efficient, which can at least partially compensate for reduced exhaust gas temperatures at near the exit 154 of the exhaust conduit 150.

The exhaust conduit 150 comprises any suitable material capable of operating at high temperature and having high thermal conductivity, e.g. a metal or metal alloy. The exhaust conduit 150 may, for instance, comprise nickel and/or stainless steel.

The exhaust conduit 150 has a hexagonal external profile, and has six substantially flat faces arranged around its exterior. A thermoelectric generator module 120 is associated with each of these faces, arranged in thermal contact therewith.

Each thermoelectric generator module 120 substantially covers the flat face with which it is associated, and comprises a coolant housing 140, a plurality of thermoelectric modules 160, and a condenser 130.

Each thermoelectric module 160 comprises a first surface 161 and a second surface 162, and is configured so that a voltage is generated by a temperature difference between the first and second surfaces 161, 162 as a result of the Seebeck effect. The voltage produced is substantially proportional to the temperature difference between the first surface 161 and the second surface 162.

When the voltage is connected to an electrical load, a current will flow, and electrical power will be generated by the thermoelectric module. This flow of current through the thermoelectric module will result in a heat flow, due to the Peltier effect. When the temperature of the first surface 161 is greater than the temperature of the second surface 162, the resulting current flow through the device (when a load is connected) will result in a heat flow from the first surface 161 to the second surface 162, due to the Peltier effect. As will be explained below, the Peltier effect can be used to control heat flux through the thermoelectric module.

The electrical power produced by a thermoelectric module 160 can be maximised by maintaining the largest possible temperature difference between the first surface 161 and the second surface 162.

The first surface 161 of each thermoelectric module 160 is in conductive thermal contact with the exhaust conduit 150. The second surface 162 of each thermoelectric module is arranged to be cooled by a coolant fluid 145 within the coolant housing 140.

The coolant housing 140 is substantially cuboidal, and conforms to the flat face of the exhaust conduit 150 with which it is associated. A first wall 141 of the coolant housing 140 that is adjacent to the exhaust conduit 150 is provided with a number of apertures, each aperture corresponding with a thermoelectric module 160. The coolant housing 140 further comprises a second wall 142, opposite the first wall 141 and remote from the exhaust conduit 150. The second wall 142 is adapted to collapse bubbles by condensing vapour from which the bubbles are comprised. The second wall may comprise a cooling means to achieve this. The cooling means may comprise an ambient air cooling arrangement. The cooling means may comprise a fluid conduit through which a wall coolant fluid may be passed to remove heat from the second wall 142. The wall coolant fluid may comprise ambient air or any suitable coolant fluid, which may comprise water. The fluid conduit of the cooling means may comprise any suitable geometry, such as serpentine, spiral and/or coiled. Enhancing the rate at which bubbles collapse enhances the pool boiling process.

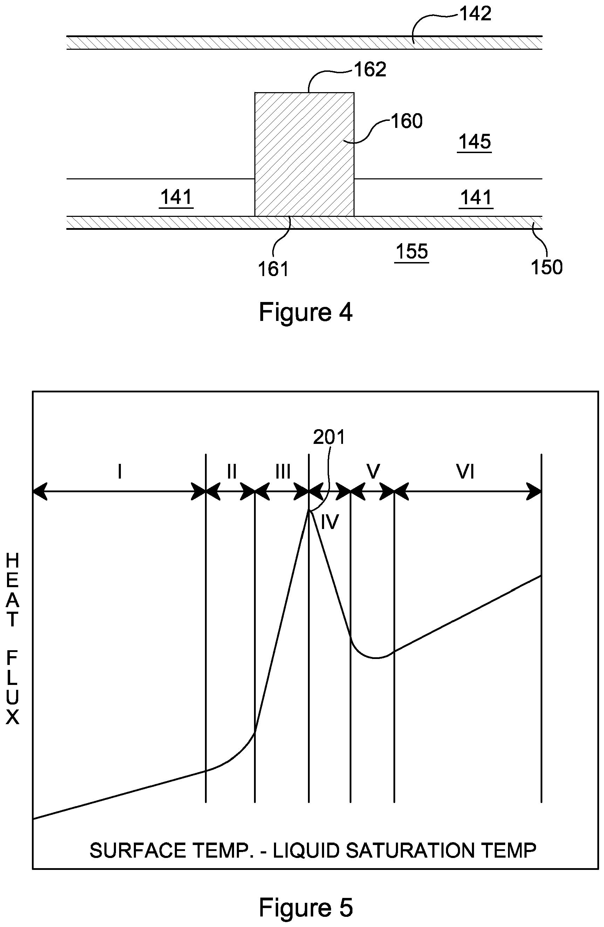

Each thermoelectric module 160 is arranged to extend through its associated aperture in the first wall 141 of the coolant housing 140, so that coolant 145 within the coolant housing 140 may directly contact the second surface 162 of the thermoelectric module 160. This is more clearly shown (schematically) in Figure 4. The first wall 141 may comprise insulating material, so as to maximise the heat flux flowing through the thermoelectric module 160, and to minimise heat input to the coolant fluid 145 within the housing 140 from any other route. The first wall 141 may have a low heat capacity.

The coolant fluid 145 may conveniently comprise water.

The second surface 162 of each thermoelectric module 160 is configured to promote nucleate boiling. The second surface 162 may comprise a porous material or a porous layer, such as a sintered metal or ceramic. In other embodiments, the second surface 162 may comprise a structured regular array of cavities or protrusions that are designed to promote and sustain nucleate boiling.
The condenser 130 comprises a serpentine flow channel that is fixed to the second wall 142, in thermal contact therewith. A further coolant fluid may flow through the condenser 130, to condense vapour within the coolant housing 140 that has vaporised as a result of heat transfer from the thermoelectric modules 160.

The thermoelectric generator 100 may be used to generate electrical power in the following way. The exhaust conduit 150 is connected into an exhaust system, so that hot exhaust gases flow through the exhaust conduit 150. The exhaust system is preferably an exhaust from a vehicle engine, such as a gasoline or diesel engine of a car. The coolant reservoirs 140 are each charged with coolant fluid 145 (for example comprising water). The condensers 130 are connected to a further cooling system which is configured to reject heat to ambient air, which may be the cooling system of the engine.
The hot exhaust passing through the exhaust conduit 150 transfers heat to the exhaust conduit 150. Each thermoelectric module 160 has a first face 161 in conductive thermal contact with the exhaust conduit 150, and heat is thereby transferred into each thermoelectric module 160 through the respective first faces 161 thereof. The second face 162 of each thermoelectric module 160 is arranged in direct contact with the coolant fluid 145. Boiling of the coolant fluid 145 at the second face 162 keeps the temperature of the second face at a temperature that is relatively close to the boiling point (saturation temperature) of the coolant fluid 145. The vapour formed by boiling of the coolant fluid 145 is condensed at the condenser 130, which returns the liquid coolant 145 to the coolant housing 140 so that it may return to contact with the second surface 162.
In this example embodiment, there are a plurality of hot surfaces, including the second face 162, in direct thermal contact with the coolant fluid 145. The hot surfaces comprising the second face 162 may include a curved or dome shaped portion, and/or may comprise sidewalls of the thermoelectric module 160. The second face 162 may comprise a curved or dome shaped surface.

For a vehicle engine exhaust the temperature may be between 520°C and 600°C downstream of the catalytic converter, or between 700°C and 900°C upstream of the catalytic converter. Assuming that the coolant fluid 145 is water, the temperature of the first side 161 may be up to 900°C, and the temperature of the second side 162 may be approximately 100°C, or may be just below 100°C, for example around 90°C.

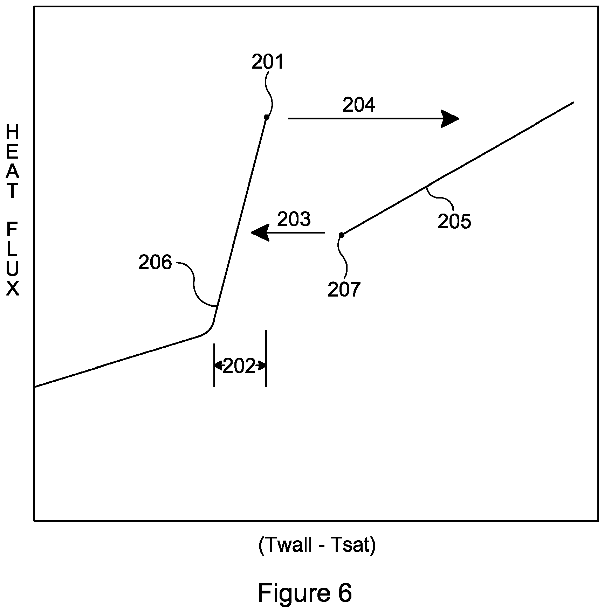

Figures 5 and 6 show the relationship between the heat flux at the second surface 162, and the temperature at the second surface 162 (expressed as a difference in temperature between the second surface 162 and the boiling point of the coolant fluid 145) for pool boiling cooling. At a low temperature difference, in regime I, the heat transfer is purely convective, with heated or superheated liquid rising to evaporate at a liquid interface. As the temperature difference increases, in regime II vapour bubbles start to form in the liquid, and in regime III there is nucleate boiling with bubbles rising to the surface.

A sharp increase in the heat flux occurs with the onset of nucleate boiling, indicated by III in Figure 5. In nucleate boiling III, there is a stable film of liquid in contact with the second surface 162, and bubbles of vapour are constantly being formed. When the temperature of the second surface 162 rises above a critical temperature 201, the boiling becomes unstable (regime IV) forming unstable regions in which vapour is in contact with the surface 162. The heat transfer is greatly reduced by this, because the thermal conductivity of vapour is low. Eventually, the temperature becomes sufficiently high for a stable film of vapour to form on the surface 162 (regimes V and VI). In regime VI, radiation becomes a dominant heat transfer mechanism.
It is desirable to maintain boiling in the nucleate boiling regime III, since this minimises the temperature of the second surface 162, while accommodating the maximum heat flux. Since the heat flux through the thermoelectric module 160 is proportional to the temperature of the first side 161, this allows a large temperature difference to be maintained across the module 160.

Certain embodiments of the thermoelectric generator comprise a controller (not shown), e.g. an MPPT controller, which is operable to control the conditions associated with heat transfer at the second surface 162 so as to maintain boiling in regime III. In one embodiment, the controller may be configured to control the current through each thermoelectric module. As already noted, the current through the thermoelectric module results in an additional heat flux from the first surface 161 to the second surface 162 as a result of the Peltier effect. The controller may control the current through the device to control this heat flux.

For example, the controller may comprise an electronic switch operable to connect and disconnect a load from each thermoelectric module. The controller may thereby control the current by pulse width modulation, switching the load in and out of the circuit as necessary. When the temperature at the first surface 161 is rising (along 206) towards a point where the heat flow through the thermoelectric module 160 will cause the temperature of the second side 162 to exceed the critical temperature 201 when it is connected to a load, the current arising from the Seebeck effect may be progressively reduced to reduce the Peltier heat flux through the device. This will reduce the temperature at the second surface 162 and maintain boiling in regime III (202). Otherwise, the temperature difference between the second surface 162 and the saturation temperature may exceed the critical temperature 201, resulting in an excursion (indicated by arrow 204) into regime VI, in which heat transfer is radiation dominated, and a stable vapour film is formed on the second surface 162.

When the stable vapour film has formed on the second surface 162 and cooling is in regime VI, the current may be reduced to bring the boiling back into regime III. A transition temperature for the second surface 207 will result in the boiling reverting back to regime III (as indicated by arrow 203). Following this transition, the current through the thermoelectric module may be increased again, as illustrated by Figure 6.

In some embodiments, the controller may be configured to drive current through the thermoelectric module in the opposite direction than would be produced by the voltage arising from the Seebeck effect. This will have the effect of causing heat to flow from the second surface 162 to the first surface 161, reducing the temperature of the second surface 162. This provides a further mechanism by which an excursion beyond the critical temperature into a stable vapour film boiling regime may be recovered.

In other embodiments, the pressure within the coolant housing 140 may be controlled to control the saturation temperature of the coolant fluid 145. Changing the balance between the rate at which of vapour is produced at the second surface 162 of each thermoelectric module 160 and the rate at which vapour is condensed back into liquid at the condenser allows the pressure to be controlled. If more vapour is produced than is condensed, the pressure will rise, and vice versa. An increased coolant pressure will in turn increase the saturation temperature of the coolant 145, so that the temperature difference between the second surface 162 and the saturation temperature is reduced. Effectively, controlling the pressure within the coolant housing 140 allows the position on the x axis of Figure 6 to be controlled, which enables control over the heat transfer regime at the surface 162. For example, conditions can be brought back into regime III following an accidental excursion into regime VI.

The rate at which the condenser condenses the coolant fluid can be controlled by changing the temperature of the condenser, for example by varying the rate of flow of the condenser coolant therethrough, or by varying the temperature of the coolant. The temperature of the condenser coolant may be varied by controlling heat transfer to the ambient air, for example by varying a fan speed on a radiator.

Although an example embodiment has been described comprising a plurality of thermoelectric generator modules 120, in some embodiments there may be only a single generator module 120, which may comprise only a single thermoelectric module 160.

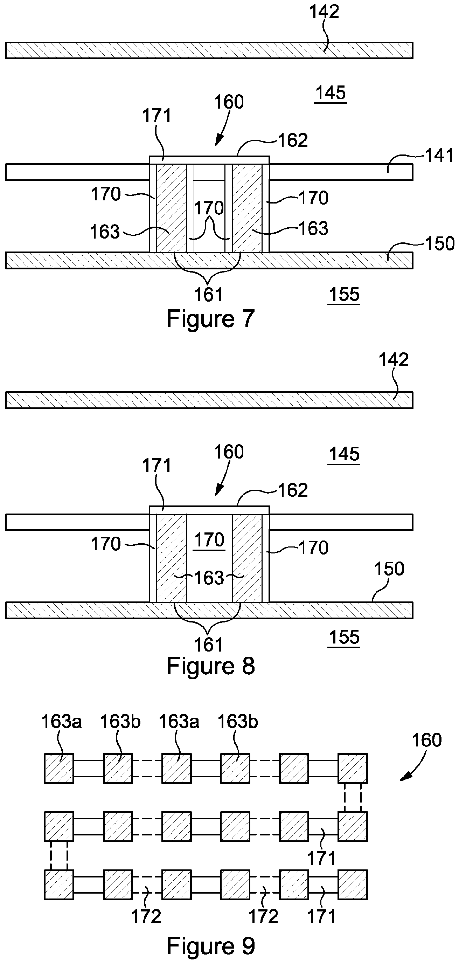

Figure 7 illustrates an example thermoelectric module 160 comprising a first and second thermoelectric pellet 163. The first pellet 163 may comprise an n-type material and the second pellet 163 may comprise a p-type material. A first surface 161 of the thermoelectric module 160 is thermally coupled to a waste heat source 150. A thermally and electrically conducting element 171 of the thermoelectric module 160 comprises a second surface 162 which is in contact with a coolant 145. Each of the pellets 163 has a first end surface in the thermal contact with a waste heat source 150, and a second opposite end surface in contact with the conducting element 171. The other surfaces of the thermoelectric pellets 163 are coated with an insulating material 170. The insulating material 170 may be deposited or otherwise formed on the surfaces of the thermoelectric pellets 163 by any suitable technique, including: dip coating, vapour phase deposition, screen printing or any combination of these techniques.

The insulating material 170 may be a thin layer. The thickness of the insulating material 170 may be less than or equal to: 5mm, 4mm, 3mm, 2mm, 1mm, 0.5mm, 250µm, 100µm.

The thermally insulating layer 170 assists in maintaining the maximum thermal gradient through each thermoelectric pellet 163, thereby increasing the efficiency of power generation for a given heat flux through the thermoelectric module 160.

Figure 8 shows a thermoelectric module 160 which has been formed or built directly onto a surface of the waste heat source 150. The thermoelectric module 160 is similar to that shown in Figure 7, but the insulating material 170 fills the space between each thermoelectric pellet 163 of the thermoelectric module 160. The thermoelectric pellets 163 and the insulating material 170 could for instance be built on the outer surface of an engine cylinder 150, which is in turn immersed in a coolant 145 into which the second surface 162 rejects heat.

Referring to Figure 9, a plan view of a thermoelectric module 160 is shown, comprising a rectangular array of thermoelectric pellets 163 a, 163b (not all of which are labelled for clarity). The array of thermoelectric pellets 163a, 163b comprises a plurality of pairs of pellets, with a first pellet 163a of each pair comprising a first material, and a second pellet 163b of each pair comprising a different second material. The first and second pellet 163a, 163b of each pair of pellets are connected at a first end by an electrical conductor 171. A first pellet 163a of each pair of pellets is connected to a second pellet 163b of a further pair of pellets by a further conducting link 172 at the second opposite end of the pellets. The pellet couples 163a, 163b are thereby connected together electrically in series, and are connected thermally in parallel between the first surface 161 and second surface 162 of the module 160.

A thermoelectric module 160 and/or pellet 163 of any embodiment may comprise any thermoelectric materials, for example: chalcogenides, half-heusler alloys, skutterudites, sulphides, oxides, organic materials including PEDOT:PSS (poly(3,4-ethylenedioxylthiophene):poly(styrene sulfonate)), polyaniline, clathrates, and zintl phase materials (including ZnSb).

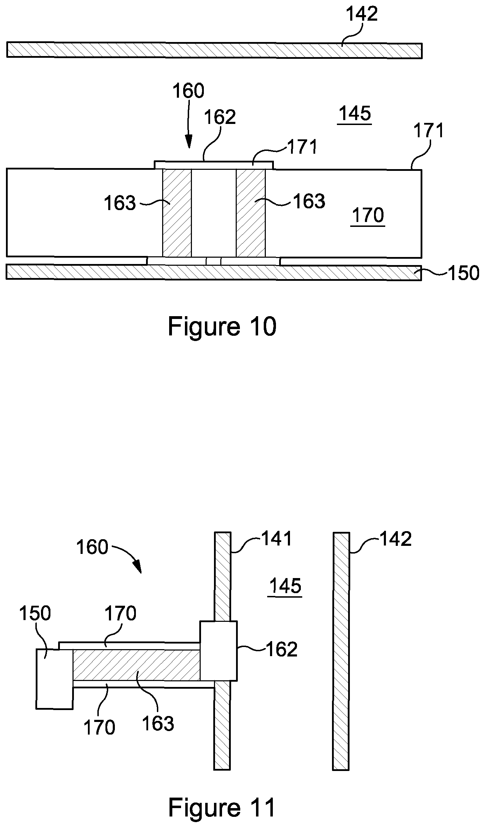

Referring to Figure 10, a thermoelectric module 160 is shown in which surfaces of the pellets 163 that are not in thermal contact with the waste heat source 150 (i.e. the surfaces that are not at the first or second end of the pellets 163) are insulated by a gas 170. The gas 170 is housed within a hermetically sealed container 171. The first surface 161 of the thermoelectric module is either external to, or part of the container 171, so that it is not thermally insulated by the gas 170. The second surface 162 of the thermoelectric module is likewise external to, or part of the container 171, so that it is not thermally insulated by the gas 170. A heat spreader may be attached to either (or both of) the first or second surface 161, 162. The gas 170 may comprise an inert gas such as argon, or any other suitable gas (for instance, an alternative noble gas or nitrogen). The gas 170 is preferably at a pressure lower than atmospheric pressure.

Figure 11 shows an alternative embodiment of a thermoelectric module 160 in which the thermoelectric pellet 163 is configured in an in-plane layout such that the direction of heat flow is in a horizontal direction.

In some embodiments, the thermoelectric generator may comprise a thermoelectric generator module that conforms to a curved surface. The curved surface may be cylindrical or spherical. In some embodiments, the thermoelectric generator may comprise one or more thermoelectric generator modules that is/are substantially cylindrical.

Specific embodiments have been described in which the waste heat source comprises an exhaust, but this is not essential, and embodiments of the present invention are applicable to any type of heat source. Example heat sources may include internal combustion engines (e.g. an engine block), stoves, and solar heat sources.

In some embodiments, at least one thermoelectric module may comprise a p-n type device. In other embodiments, at least one thermoelectric module may comprise a p-type only or n-type only type device.

It will be appreciated that the features of any embodiment described herein may be combined with the features of another embodiment. The skilled person will appreciate that a number of other modifications and variations are possible, without departing from the scope of the invention, as defined by the appended claims.

## Claims

1. A method of generating electrical power from waste heat comprising:
providing waste heat to a first surface (161) of a thermoelectric module (160);
cooling a second surface (162) of the thermoelectric module (160) using pool boiling of a coolant fluid (145), thereby producing electrical power from the thermoelectric module (160) as a result of a temperature difference between the first surface(161) and the second surface (162);
condensing, at a condenser (130), a coolant vapour formed by pool boiling of the coolant fluid (145); and
controlling the heat transfer conditions associated with rejecting heat from the second surface (162) to the coolant fluid (145) so as to promote and maintain nucleate boiling of the coolant fluid (145) in response to heat rejected from the second surface (162).

2. The method of claim 1, wherein the heat flux through the second surface (162) is controlled by controlling the current through the thermoelectric module (160), thereby controlling the degree of heat transfer associated with the Peltier effect, and optionally wherein controlling the current through the thermoelectric module (160) comprises controlling when a load is connected and disconnected from the thermoelectric module (160).

3. The method of claim 1 or claim 2, wherein the boiling point of the coolant fluid (145) is controlled by controlling the pressure of the coolant fluid (145), optionally wherein the pressure of the coolant fluid (145) is controlled by controlling a rate at which a coolant vapour, formed by boiling of the coolant fluid (145), is condensed at a condenser (130).

4. The method of any preceding claim, comprising arranging the coolant fluid (145) and thermoelectric module (160) so that the coolant fluid (145) is in direct contact with the second surface (162).

5. The method of claim 4, further comprising selecting a surface morphology for the second surface (162) that promotes nucleate boiling, comprising selecting a surface material that is at least partially porous, or coating at least part of the second surface (162) with a porous layer, and/or patterning the second surface (162) with a plurality of nucleation sites for nucleation of boiling, wherein patterning the surface preferably comprises machining the surface to create an array of cavities and/or projections, the cavities and/or projections comprising nucleation sites.

6. The method of any preceding claim, wherein the waste heat is from a vehicle, and/or wherein the waste heat is exhaust waste heat.

7. The method of any preceding claim, comprising using an insulation means (170) to insulate a further surface of the thermoelectric module (160), preferably wherein the insulation means (170) is provided by depositing an insulating layer onto the further surface, and/or preferably, wherein the insulation means (170) comprises a gas such as a substantially chemically inert gas, the method optionally comprising housing the gas (170) in an hermetically sealed container (171).

8. A thermoelectric generator (100) for use with a waste heat source (150), the thermoelectric generator (100) comprising:
a coolant housing (140), a condenser (130);
a thermoelectric module (160) comprising a first surface (161) and a second surface (162); and
a controller which is configured to control the heat transfer conditions associated with rejecting heat from the second surface (162) to the coolant fluid (145) so as to promote and maintain nucleate boiling of the coolant fluid (145) in response to heat rejected from the second surface (162);
wherein the thermoelectric module (160) is arranged so that, in use, the first surface (161) receives heat from the waste heat source (150), and the second surface (162) rejects heat into a coolant fluid (145) within the coolant housing (140), so as to generate electrical power from the resulting temperature difference between the first surface (161) and the second surface (162);
wherein the coolant housing (140) is arranged to receive a liquid coolant fluid (145) from the condenser (130), to house the liquid coolant fluid (145) that receives heat from the second surface (162) of the thermoelectric module (160) so as to produce a coolant fluid vapour by pool boiling, and to communicate the coolant fluid vapour to the condenser (130);
wherein the condenser (130) is configured to condense the coolant fluid vapour to produce liquid coolant fluid (145).

9. The thermoelectric generator of claim 8, wherein the controller is configured to control the heat flux through the second surface (162) by controlling the current flow through the thermoelectric module (160).

10. The thermoelectric generator of claim 8 or 9, wherein the controller is configured to control the pressure of the coolant fluid (145) within the fluid housing (140), optionally wherein the controller is configured to control the pressure of the coolant fluid (145) by controlling a rate of condensation at the condenser (130).

11. The thermoelectric generator of any of claims 8 to 10, wherein the thermoelectric module (160) is arranged so that, in use, coolant fluid (145) within the reservoir (140) can be brought into direct contact with the second surface (162).

12. The thermoelectric generator of claim 11, wherein the second surface (162) is configured to promote nucleate boiling, preferably by being at least partially porous, or comprising a porous layer, and/or comprising an array of cavities and/or projections.

13. The thermoelectric generator of any of claims 8 to 12, comprising insulation means (170) arranged to insulate a further surface of the thermoelectric module (160), preferably wherein the insulation means (170) is an insulating layer deposited onto the further surface, and/or preferably wherein the insulation means (170) comprises a gas such as a substantially chemically inert gas, and optionally further comprising a hermetically sealed container (171) housing the gas (170).

14. The method of any of claims 1 to 7, comprising using the thermoelectric generator (100) according to any of claims 8 to 13.

15. A structure with a waste heat source (150), and a thermoelectric generator (100) according to any of claims 8 to 13 arranged to produce electricity from the waste heat source (150).

## Patentansprüche

1. Verfahren zum Erzeugen elektrischer Energie aus Abwärme, umfassend:
Bereitstellen einer Abwärme an einer ersten Oberfläche (161) eines thermoelektrischen Moduls (160);
Kühlen einer zweiten Oberfläche (162) des thermoelektrischen Moduls (160) mithilfe eines Behältersiedens eines Kühlmediums (145), wodurch von dem thermoelektrischen Modul (160) eine elektrische Energie als ein Ergebnis einer Temperaturdifferenz zwischen der ersten Oberfläche (161) und der zweiten Oberfläche (162) erzeugt wird;
Kondensieren in einem Verflüssiger (130) eines Kühlmitteldampfs, der durch das Behältersieden des Kühlmediums (145) gebildet wird; und
Regeln der Wärmeübertragungsbedingungen, die der Wärmeabgabe von der zweiten Oberfläche (162) an das Kühlmedium (145) zugeordnet sind, um als Reaktion auf die von der zweiten Oberfläche (162) abgegebene Wärme ein Blasensieden des Kühlmediums (145) zu fördern und aufrechtzuerhalten.

2. Verfahren nach Anspruch 1, wobei der Wärmefluss durch die zweite Oberfläche (162) geregelt wird, indem der Strom durch das thermoelektrische Modul (160) geregelt wird, wodurch der Grad der Wärmeübertragung geregelt wird, die dem Peltier-Effekt zugeordnet ist, und wobei optional das Regeln des Stroms durch das thermoelektrische Modul (160) ein Regeln umfasst, wenn eine Last an das thermoelektrische Modul (160) angeschlossen oder davon getrennt wird.

3. Verfahren nach Anspruch 1 oder Anspruch 2, wobei der Siedepunkt des Kühlmediums (145) geregelt wird, indem der Druck des Kühlmediums (145) geregelt wird, wobei optional der Druck des Kühlmediums (145) geregelt wird, indem eine Rate geregelt wird, mit welcher der Kühlmitteldampf, der durch das Sieden des Kühlmediums (145) gebildet wird, in einem Verflüssiger (130) kondensiert wird.

4. Verfahren nach einem der vorhergehenden Ansprüche, das ein Anordnen des Kühlmediums (145) und des thermoelektrischen Moduls (160) umfasst, sodass das Kühlmedium (145) in einem direkten Kontakt mit der zweiten Oberfläche (162) steht.

5. Verfahren nach Anspruch 4, das außerdem ein Auswählen einer Oberflächenmorphologie für die zweite Oberfläche (162) umfasst, die das Blasensieden fördert, wobei das Auswählen umfasst:
Auswählen eines Oberflächenmaterials, das mindestens teilweise porös ist; oder
Beschichten mindestens eines Teils der zweiten Oberfläche (162) mit einer porösen Schicht und/oder Gestalten der zweiten Oberfläche (162) mit einer Vielzahl von Dampfblasenbildungsorten zur Dampfblasenbildung beim Sieden,
wobei das Gestalten der Oberfläche vorzugsweise ein maschinelles Bearbeiten der Oberfläche umfasst, um eine Matrix von Hohlräumen und/oder Ausbuchtungen zu erstellen, wobei die Hohlräume und/oder Ausbuchtungen die Dampfblasenbildungsorte umfassen.

6. Verfahren nach einem der vorhergehenden Ansprüche, wobei die Abwärme von einem Fahrzeug stammt und/oder wobei die Abwärme eine Abgasabwärme ist.

7. Verfahren nach einem der vorhergehenden Ansprüche, das ein Verwenden eines Wärmedämmelements (170) umfasst, um eine weitere Oberfläche des thermoelektrischen Moduls (160) zu dämmen,
wobei das Wärmedämmelement (170) vorzugsweise durch ein Abscheiden einer Wärmedämmschicht auf der weiteren Oberfläche bereitgestellt wird, und/oder
wobei das Wärmedämmelement (170) vorzugsweise ein Gas wie zum Beispiel ein im Wesentlichen chemisches Inertgas umfasst, wobei das Verfahren optional ein Aufbewahren des Gases (170) in einem hermetisch abgedichteten Behälter (171) umfasst.

8. Thermoelektrischer Generator (100) zur Verwendung mit einer Abwärmequelle (150), wobei der thermoelektrische Generator (100) umfasst:
ein Kühlmittelgehäuse (140);
einen Verflüssiger (130);
ein thermoelektrisches Modul(160) das eine erste Oberfläche (161) und eine zweite Oberfläche (162) umfasst; und
eine Steuereinheit, die konfiguriert ist, die Wärmeübertragungsbedingungen zu regeln, die der Wärmeabgabe von der zweiten Oberfläche (162) an das Kühlmedium (145) zugeordnet sind, um als Reaktion auf die von der zweiten Oberfläche (162) abgegebene Wärme ein Blasensieden des Kühlmediums (145) zu fördern und aufrechtzuerhalten;
wobei das thermoelektrische Modul (160) so angeordnet ist, dass im Betrieb die erste Oberfläche (161) Wärme von der Abwärmequelle (150) aufnimmt und die zweite Oberfläche (162) Wärme in ein Kühlmedium (145) innerhalb des Kühlmittelgehäuses (140) abgibt, um elektrische Energie zu erzeugen, die sich aus der Temperaturdifferenz zwischen der ersten Oberfläche (161) und der zweiten Oberfläche (162) ergibt;
wobei das Kühlmittelgehäuse (140) so angeordnet ist, dass es ein flüssiges Kühlmedium (145) von dem Verflüssiger (130) empfängt, dass es das flüssige Kühlmedium (145) aufbewahrt, das die Wärme von der zweiten Oberfläche (162) des thermoelektrischen Moduls (160) empfängt, um durch eine Behältersieden einen Kühlmitteldampf herzustellen, und dass es den Kühlmitteldampf an den Verflüssiger (130) leitet;
wobei der Verflüssiger (130) konfiguriert ist, den Kühlmittel Dampf zu kondensieren, um das flüssige Kühlmedium (145) herzustellen.

9. Thermoelektrischer Generator nach Anspruch 8, wobei die Steuereinheit konfiguriert ist, um den Wärmefluss durch die zweite Oberfläche (162) zu regeln, indem der Stromfluss durch das thermoelektrische Modul (160) geregelt wird.

10. Thermoelektrischer Generator nach Anspruch 8 oder 9, wobei die Steuereinheit konfiguriert ist, um den Druck des Kühlmediums (145) in dem Kühlmittelgehäuse (140) zu regeln, wobei die Steuereinheit optional konfiguriert ist, um den Druck des Kühlmediums (145) zu regeln, indem eine Kondensationsrate in dem Verflüssiger (130) geregelt wird.

11. Thermoelektrischer Generator nach einem der Ansprüche 8 bis 10, wobei das thermoelektrische Modul (160) so angeordnet ist, dass im Betrieb das Kühlmedium (145) in dem Tank (140) in einen direkten Kontakt mit der zweiten Oberfläche (162) gebracht werden kann.

12. Thermoelektrischer Generator nach Anspruch 11, wobei die zweite Oberfläche (162) konfiguriert ist, um ein Blasensieden zu fördern, vorzugsweise indem sie mindestens teilweise porös ist oder eine poröse Schicht umfasst und/oder eine Matrix aus Hohlräumen und/oder Ausbuchtungen umfasst.

13. Thermoelektrischer Generator nach einem der Ansprüche 8 bis 12, das ein Wärmedämmelement (170) umfasst, das angeordnet ist, um eine weitere Oberfläche des thermoelektrischen Moduls (160) zu dämmen, wobei das Wärmedämmelement (170) vorzugsweise eine Wärmedämmschicht ist, die auf der weiteren Oberfläche abgeschieden wird, und/oder wobei das Wärmedämmelement (170) vorzugsweise ein Gas wie zum Beispiel ein im Wesentlichen chemisches Inertgas umfasst, und optional außerdem einen hermetisch abgedichteten Behälter (171) umfasst, in dem das Gas (170) aufbewahrt wird.

14. Verfahren nach einem der Ansprüche 1 bis 7, das ein Verwenden des thermoelektrischen Generators (100) nach einem der Ansprüche 8 bis 13 umfasst.

15. Struktur mit einer Abwärmequelle (150) und einem thermoelektrischen Generator (100) nach einem der Ansprüche 8 bis 13, der angeordnet ist, um von der Abwärmequelle (150) Elektrizität zu erzeugen.

## Revendications

1. Procédé de génération d'énergie électrique à partir de chaleur perdue, comportant les étapes consistant à :
fournir de la chaleur perdue à une première surface (161) d'un module thermoélectrique (160) ;
refroidir une deuxième surface (162) du module thermoélectrique (160) par ébullition libre d'un fluide (145) de refroidissement, produisant ainsi énergie électrique à partir du module thermoélectrique (160) du fait d'une différence de température entre la première surface (161) et la deuxième surface (162) ;
condenseur, au niveau d'un condenseur (130), une vapeur d'agent de refroidissement formée par ébullition libre du fluide (145) de refroidissement ; et
réguler les conditions de transfert de chaleur associées au rejet de chaleur de la deuxième surface (162) vers le fluide (145) de refroidissement de façon à favoriser et à entretenir une ébullition nucléée du fluide (145) de refroidissement en réaction à de la chaleur rejetée à partir de la deuxième surface (162).

2. Procédé selon la revendication 1, le flux de chaleur à travers la deuxième surface (162) étant régulé en régulant le courant à travers le module thermoélectrique (160), régulant ainsi le degré de transfert de chaleur associé à l'effet Peltier, et la régulation du courant à travers le module thermoélectrique (160) comportant éventuellement la commande des instants où une charge est connectée au module thermoélectrique (160) et déconnectée de celui-ci.

3. Procédé selon la revendication 1 ou la revendication 2, le point d'ébullition du fluide (145) de refroidissement étant régulé en régulant la pression du fluide (145) de refroidissement, la pression du fluide (145) de refroidissement étant éventuellement régulée en régulant une vitesse à laquelle une vapeur d'agent de refroidissement, formée par l'ébullition du fluide (145) de refroidissement, est condensée au niveau d'un condenseur (130).

4. Procédé selon l'une quelconque des revendications précédentes, comportant l'étape consistant à disposer le fluide (145) de refroidissement et module thermoélectrique (160) de telle façon que le fluide (145) de refroidissement soit en contact direct avec la deuxième surface (162).

5. Procédé selon la revendication 4, comportant en outre les étapes consistant à sélectionner pour la deuxième surface (162) une morphologie de surface qui favorise l'ébullition nucléée, ce qui comporte les étapes consistant à sélectionner un matériau de surface qui est au moins partiellement poreux, ou à revêtir au moins une partie de la deuxième surface (162) d'une couche poreuse, et/ou à appliquer un motif à la deuxième surface (162) avec une pluralité de sites de nucléation servant à la nucléation de l'ébullition, l'application d'un motif à la surface comportant de préférence l'usinage de la surface pour créer un réseau de cavités et/ou de protubérances, les cavités et/ou les protubérances comportant des sites de nucléation.

6. Procédé selon l'une quelconque des revendications précédentes, la chaleur perdue provenant d'un véhicule, et/ou la chaleur perdue étant une chaleur perdue d'échappement.

7. Procédé selon l'une quelconque des revendications précédentes, comportant l'utilisation d'un moyen (170) d'isolation pour isoler une autre surface du module thermoélectrique (160), le moyen (170) d'isolation étant de préférence réalisé en déposant une couche isolante sur l'autre surface, et/ou le moyen (170) d'isolation comportant de préférence un gaz tel qu'un gaz sensiblement inerte chimiquement, le procédé comportant éventuellement l'étape consistant à loger le gaz (170) dans un récipient (171) hermétiquement scellé.

8. Générateur thermoélectrique (100) destiné à être utilisé avec une source (150) de chaleur perdue, le générateur thermoélectrique (100) comportant :
un boîtier (140) pour agent de refroidissement, un condenseur (130) ;
un module thermoélectrique (160) comportant une première surface (161) et une deuxième surface (162) ; et
un régulateur qui est configuré pour réguler les conditions de transfert de chaleur associées au rejet de chaleur de la deuxième surface (162) vers le fluide (145) de refroidissement de façon à favoriser et à entretenir une ébullition nucléée du fluide (145) de refroidissement en réaction à de la chaleur rejetée à partir de la deuxième surface (162) ;
le module thermoélectrique (160) étant disposé de telle façon qu'en cours d'utilisation, la première surface (161) reçoive de la chaleur en provenance de la source (150) de chaleur perdue, et que la deuxième surface (162) rejette de la chaleur dans un fluide (145) de refroidissement à l'intérieur du boîtier (140) pour agent de refroidissement, de façon à générer de l'énergie électrique issue de la différence de température qui en résulte entre la première surface (161) et la deuxième surface (162) ;
le boîtier (140) pour agent de refroidissement étant disposé pour recevoir un fluide (145) de refroidissement liquide en provenance du condenseur (130), pour renfermer le fluide (145) de refroidissement liquide qui reçoit de la chaleur provenant de la deuxième surface (162) du module thermoélectrique (160) de façon à produire un vapeur de fluide de refroidissement par ébullition libre, et pour communiquer la vapeur de fluide de refroidissement au condenseur (130) ;
le condenseur (130) étant configuré pour condenser la vapeur de fluide de refroidissement pour produire du fluide (145) de refroidissement liquide.

9. Générateur thermoélectrique selon la revendication 8, le régulateur étant configuré pour réguler le flux de chaleur à travers la deuxième surface (162) en régulant la circulation de courant à travers le module thermoélectrique (160).

10. Générateur thermoélectrique selon la revendication 8 ou 9, le régulateur étant configuré pour réguler la pression du fluide (145) de refroidissement à l'intérieur du boîtier (140) pour fluide, le régulateur étant éventuellement configuré pour réguler la pression du fluide (145) de refroidissement en régulant une vitesse de condensation au niveau du condenseur (130).

11. Générateur thermoélectrique selon l'une quelconque des revendications 8 à 10, le module thermoélectrique (160) étant disposé de telle façon qu'en cours d'utilisation, du fluide (145) de refroidissement à l'intérieur du réservoir (140) puisse être amené en contact direct avec la deuxième surface (162).

12. Générateur thermoélectrique selon la revendication 11, la deuxième surface (162) étant configurée pour favoriser une ébullition nucléée, de préférence en étant au moins partiellement poreuse, ou en comportant une couche poreuse, et/ou en comportant un réseau de cavités et/ou de protubérances.

13. Générateur thermoélectrique selon l'une quelconque des revendications 8 à 12, comportant un moyen (170) d'isolation disposé de façon à isoler une autre surface du module thermoélectrique (160), le moyen (170) d'isolation étant de préférence une couche isolante déposée sur l'autre surface, et/ou le moyen (170) d'isolation comportant de préférence un gaz tel qu'un gaz sensiblement inerte chimiquement, et comportant en outre éventuellement un récipient (171) hermétiquement scellé renfermant le gaz (170).

14. Procédé selon l'une quelconque des revendications 1 à 7, comportant l'utilisation du générateur thermoélectrique (100) selon l'une quelconque des revendications 8 à 13.

15. Structure dotée d'une source (150) de chaleur perdue, et d'un générateur thermoélectrique (100) selon l'une quelconque des revendications 8 à 13 disposé de façon à produire de l'électricité à partir de la source (150) de chaleur perdue.
